# EUROPÄISCHE PATENTANMELDUNG

(11) **EP 4 020 314 A1**
(43) Veröffentlichungstag der Anmeldung: **29.06.2022**
(21) Anmeldenummer: 20216995.9
(22) Anmeldetag: 23.12.2020
(51) Int. Cl.: G06K 9/62, H05K 13/08

(54) **VERFAHREN UND VORRICHTUNG ZUR OPTISCHEN QUALITÄTSKONTROLLE WÄHREND DER FERTIGUNG VON LEITERPLATTEN**

(71) Anmelder: Siemens Aktiengesellschaft, 80333 München (DE)
(72) Erfinder: Die Erfindernennung liegt noch nicht vor

(57) **Zusammenfassung**

Verfahren zur optischen Qualitätskontrolle (Q) während der Fertigung (1) von Leiterplatten (L), umfassend: Erfassen (S3) eines Bildes (P1) einer Leiterplatte (L), und Bestimmen (S4) eines ersten Fehlerindikators (F1) mittels optischer Bildverarbeitung basierend auf dem erfassten Bild, Bestimmen (S5) eines zweiten Fehlerindikators (F2) mittels eines trainierten lernfähigen Algorithmus (ML) basierend auf dem erfassten Bild (P1), und Ausgeben (S6) des zweiten Fehlerindikators (F2), vorzugsweise anstatt des ersten Fehlerindikators (F1), als Ergebnis der Qualitätskontrolle (Q).

## Beschreibung

Aus der Europäischen Patentanmeldung mit Anmeldeaktenzeichen EP 20185488.2 ist bereits ein Verfahren zum Prüfen einer Leiterplatte bzw. einer Leiterplattenbaugruppe bekannt geworden.

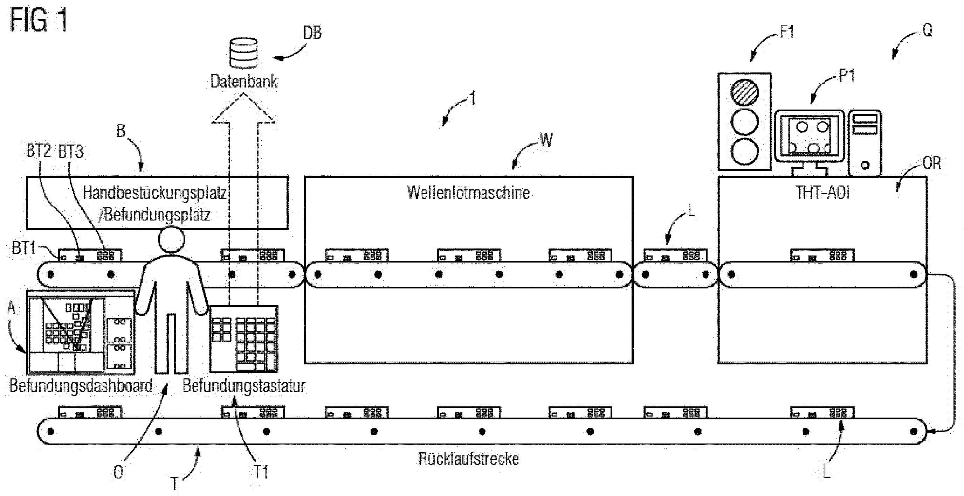

In der Leistungselektronik werden elektrische Bauteile BT1, BT2, BT3 in Durchstecktechnologie (engl. Through-Hole-Tech nology, THT) mit der Leiterplatte L elektrisch und mecha nisch verbunden, wie in FIG 1 gezeigt. Zumeist werden die elektrischen Bauelemente an einem Bestückplatz B, wie bspw. einem Handbestückplatz oder mithilfe eines Bestückroboters, in Aufnahmebohrungen auf der Leiterplatte L gesteckt. Die Leiterplatte L fährt zusammen mit den gesteckten elektrischen Bauteilen BT1, BT2, BT3 in eine Wellenlötmaschine W, wo sie über eine Lötwelle gezogen wird, wobei Zinn eine elektrisch leitende Verbindung zwischen der Leiterplatte L und den elektrischen Bauteilen BT1, BT2, BT3 ausprägt. Nach dem Lötprozess werden die Kontaktstellen (fortan Lötstellen) und deren Ausprägung optisch mittels eine Inspektionssystems zur Qualitätskontrolle inspiziert. Hierzu kommen zumeist automatisch optische Inspektionen (kurz: AOIs) zum Einsatz, wie in FIG 1 gezeigt. Das Inspektionssystem umfasst dabei Hardware-Komponenten für die optische Bildverarbeitung wie Kamera, Rechner und Belichtung. Mögliche Fehler, die das AOI detektieren soll sind fehlende Bauteile, schiefstehende Bauelemente, Lötstellen mit ungenügender Benetzung (kalte oder offene Lötstelle), oder Zinnbrücken, also elektrische Kontakte von Lötstellen, die elektrisches Potenzial aufweisen sollten.

Vermittels der optischen Inspektion wird dabei ein Bild P1 über eine Bilderfassung erfasst. Dieses wird in der AOI-Software, d.h. mittels einer optische Bildverarbeitung OR, softwareseitig ausgewertet. Hierzu ist zu jedem Produkt, bspw. umfassend eine Leiterplatte L und Bauteile BT1, BT2, BT3, ein Prüfprogramm hinterlegt. Wenn die optische Bildverarbeitung OR an einer Leiterplatte L einen oder mehrere Fehler feststellt, so wird diese über eine Rücklaufstrecke einem Operator 0, bspw. an einem Befundungsplatz T, zur manuellen Befundung zugeführt und vorgelegt. Der Operator O vor Ort führt nun eine manuelle Sichtprüfung, bspw, über eine Anzeigeeinheit A an einem Befundungsdashboard, durch. Mithilfe einer Befundungstastatur T1, bspw. ebenfalls an dem Befundungsdashboard, kann der Operator O nun den echten Befund eingeben. Das Ergebnis der Befundung kann in einer Datenbank DB gespeichert werden. Das Ergebnis der Befundung wird aber gem. der Ausführungsform in FIG 1 nicht der AOI-Software, insbesondere deren optischer Bildverarbeitung OR, zurückgespielt. Ein Prüfingenieur müsste daher die Prüfprogramme der AOI-Software bzw. der optischen Bildverarbeitung OR manuell pflegen und betreuen. Insbesondere bei Änderungen der Lichtverhältnisse oder Änderungen des Leiterplattenherstellers an der Leiterplatte oder anderen Einflüssen die Fertigung der Leiterplatte(n) betreffend müssten entsprechende Änderungen an einem oder mehreren der verwendeten Prüfprogramme bzw. der optischen Bildverarbeitung OR vorgenommen werden. Über etwaige o.g. Änderungen und Einflüsse wird der Prüfingenieur jedoch nicht automatisch informiert.

Es ist somit Aufgabe der Erfindung, eine Anpassung an gegebenenfalls stattfindende Änderungen bei der Fertigung bzw. Einflüsse auf die Fertigung einer oder mehreren Leiterplatten zu ermöglichen und eine verbesserte Fehlererkennung bei der Fertigung einer oder mehrerer Leiterplatten anzugeben.

Die Aufgabe wird gemäß einem ersten Aspekt durch ein Verfahren zur optischen Qualitätskontrolle während der Fertigung von Leiterplatten gelöst. Das Verfahren gem. dem ersten Aspekt umfasst die Schritte: Erfassen eines Bildes einer Leiterplatte, und Bestimmen eines ersten Fehlerindikators mittels optischer Bildverarbeitung basierend auf dem erfassten Bild. Das Verfahren gem. dem ersten Aspekt umfasst ferner die Schritte: Bestimmen eines zweiten Fehlerindikators mittels eines trainierten lernfähigen Algorithmus basierend auf dem erfassten Bild. Das Verfahren gem. dem ersten Aspekt umfasst ferner den Schritt: Ausgeben des zweiten Fehlerindikators, vorzugsweise anstatt des ersten Fehlerindikators, als Ergebnis der Qualitätskontrolle.

Die Aufgabe wird gemäß einem zweiten Aspekt durch eine Vorrichtung, insbesondere Inspektionssystem zur Fertigungskontrolle von Leiterplatten, zur Durchführung des Verfahrens nach dem ersten Aspekt gelöst.

Die Aufgabe wird gemäß einem dritten Aspekt durch ein Computerprogrammprodukt mit Programmcodemitteln, die wenn sie ausgeführt werden, zur Durchführung des Verfahrens gem. mä des ersten Aspekt dienen.

Die Erfindung wird anhand der folgenden Figuren näher beschrieben:
- FIG 1: zeigt eine schematische Darstellung einer Leiterplattenfertigung mit einer erste Ausführungsform eines Inspektionssystem zur Fertigungskontrolle.
- FIG 2: zeigt eine schematische Darstellung einer Leiterplattenfertigung mit einer zweiten Ausführungsform eines Inspektionssystem zur Fertigungskontrolle.
- FIG 3: zeigt eine schematische Darstellung eines Ablaufs einer Bildverarbeitung und Fehlerindikatorbestimmung zur Qualitätskontrolle während der Leiterplattenfertigung.
- FIG 4: zeigt eine schematische Darstellung eines Ablaufs zum (Nach-)Trainieren eines lernfähigen Algorithmus basierend auf einem Datensatz mit Befundungsinformationen.
- FIG 5: zeigt eine schematische Darstellung eines ersten Ablaufs einer Bilddatenverarbeitung für das Trainieren und während des Einsatzes eines trainierten lernfähigen Algorithmus.
- FIG 6: zeigt eine schematische Darstellung eines zweiten Ablaufs einer Bilddatenverarbeitung für das Trainieren und während des Einsatzes eines trainierten lernfähigen Algorithmus.
- FIG 7: zeigt mehrere Class Activation Maps zur Analyse, welche Teile eines Bildes eine Klassifizierungsentscheidung eines lernfähigen Algorithmus beeinflussen.
- FIG 8: zeigt eine schematische Darstellung eines Verfahrens zur Qualitätskontrolle gemäß einer ersten Ausführungsform.
- FIG 9: zeigt eine schematische Darstellung eines Verfahrens zur Qualitätskontrolle gemäß einer zweiten Ausführungsform.
- FIG 10: zeigt eine schematische Darstellung eines Verfahrens zum Trainieren eines lernfähigen Algorithmus gemäß einer dritten Ausführungsform.
- FIG 11: zeigt eine schematische Darstellung eines Verfahrens gemäß einer vierten Ausführungsform.
- FIG 12: zeigt eine schematische Darstellung eines Verfahrens gemäß einer fünften Ausführungsform.
- FIG 13: zeigt eine schematische Darstellung eines Verfahrens gemäß einer sechsten Ausführungsform.

FIG 1 zeigt eine Anlage 1 bzw. ein System zur Leiterplattenfertigung. Die Anlage 1 weist eine Fertigungslinie mit einem Inspektionssystem Q zur Qualitätskontrolle der gefertigten Leiterplatte(n) L auf. Es ist jedoch auch die Verwendung des Inspektionssystems Q zur Qualitätskontrolle bei der Fertigung eines anderen Produkts denkbar. Bspw. ist Anstelle der Qualitätskontrolle einer oder mehrerer Leiterplatten die Verwendung zur Oberflächenprüfung, Schweißnahtprüfung, Deformationserkennung und/oder Sendungsverfolgung bis hin zu Robot/Machine Vision möglich.

Die Anlage 1 weist einen Bestückplatz B zum Bestücken der Leiterplatte(n) mit elektrischen bzw. elektronischen Bauteilen BT1, BT2, BT3 auf. Die Anlage 1 weist ferner eine Wellenlötmaschine W zur Herstellung einer elektrisch leitenden Verbindung zwischen der Leiterplatte und den elektrischen Bauteilen BT1, BT2, BT3 auf. Nach dem Lötprozess werden die Kontaktstellen (fortan Lötstellen) und deren Ausprägung optisch inspiziert. Hierzu kommen zumeist automatisch optische Inspektionen, AOI, zum Einsatz.

Das Inspektionssystem Q kann jedoch, wie eingangs beschrieben, nicht dynamisch auf sich ändernde Bedingungen bzw. Einflüsse während der Fertigung reagieren bzw. eingestellt werden. Daher besteht die Möglichkeit, dass das Inspektionssystem Q zu viele der untersuchten Leiterplatten L als fehlerhaft indiziert, obwohl diese Leiterplatten L eigentlich fehlerfrei sind, sog. "false positives". Das wiederum erhöht die Anzahl der erforderlichen Nachkontrollen bzw. Befundungen. Eine Verbesserung der Erkennung von diesen "false positives" führt zu einer Reduktion des Arbeitsaufwandes.

In FIG 1 wird der erste Fehlerindikator F1, bspw. mittels optischer Bildverarbeitung OR bestimmt, über eine Anzeigeeinheit, wie bspw. eine Lichtsignalanlage, ausgegeben. Bspw. kann eine Lichtsignalanlage vorgesehen sein, die ein erstes Lichtsignal, wie bspw. rot, ausgibt, falls vermittels des Inspektionssystems Q, insbesondere vermittels der optischen Bildverarbeitung OR, ein Fehler bestimmt wurde, d.h. ein erster Fehlerindikator F1 einen Fehler indiziert bzw. ein zweites Lichtsignal anzeigt, falls kein Fehler erkannt wurde, d.h. ein erster Fehlerindikator F1 keinen Fehler indiziert.

Die optische Bildverarbeitung OR, wie bspw. eine Segmentierung oder eine Mustererkennung beziehungsweise Objekterkennung, dient zur Klassifizierung eines von der Leiterplatte erfassten Bildes bzw. eines oder mehrere Bildbereiche.

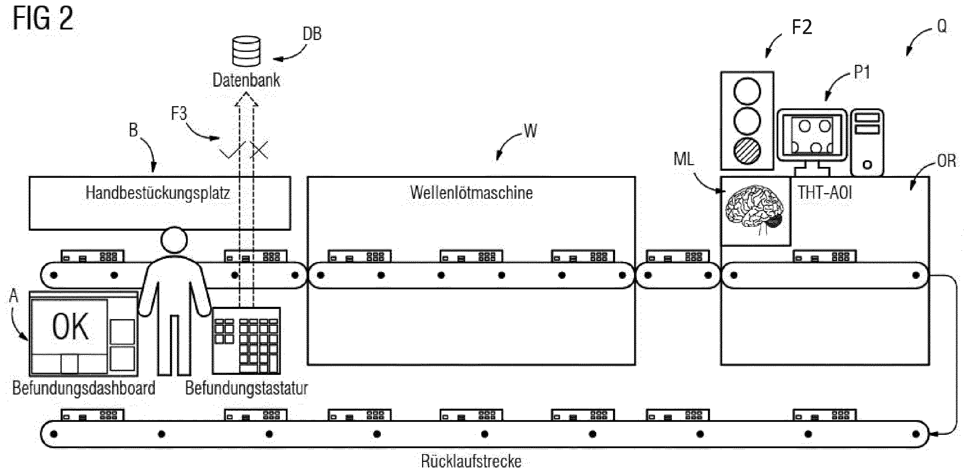

FIG 2 zeigt eine Anlage 1 mit einem verbesserten Inspektionssystem Q zur Qualitätskontrolle. Das Inspektionssystem Q verfügt über einen lernfähigen Algorithmus ML, der eine Anpassung der Qualitätskontrolle an die sich ändernden (Umgebungs-)Bedingungen bzw. Einflüsse während der Fertigung ermöglicht.

Das Inspektionssystem Q nutzt vermittels des lernfähigen Algorithmus ML das Ergebnis der Befundung(en) aus und ermöglicht es, den Aufwand zur (Re-)Programmierung der Software (module) zu optischen Bildverarbeitung OR zu reduzieren. Das Inspektionssystem Q ermöglicht ferner eine (automatische) Verbesserung der Qualitätskontrolle, indem bspw. ein (automatisches) (Nach)trainieren des lernfähigen Algorithmus ML erfolgt. Außerdem kann der First Pass Yield gesteigert werden, indem die Lötstellen vermittels des lernfähigen Algorithmus ML des Inspektionssystems Q untersucht werden. Die Ergebnisse des lernfähigen Algorithmus ML können dem Softwaremodul, vgl. Softwaremodul SWM1 weiter unten, zur optischen Bildverarbeitung OR übergeben werden. Bspw. kann die ursprüngliche Bewertung der Lötstellen durch das Softwaremodul zu optischen Bildverarbeitung OR überschrieben werden. So kann das Ergebnis des lernfähigen Algorithmus ML anstatt des Ergebnisses der optischen Bildverarbeitung OR als (Gesamt)Ergebnis der Qualitätskontrolle verwendet werden. Eine Nachkontrolle, wie bspw. eine manuelle Befundung, von einer oder mehreren durch die optische Bildverarbeitung OR als fehlerhaft indizierten Leiterplatten L vom Inspektionssystem Q, wird somit vorab von dem lernfähigen Algorithmus ML übernommen. Eine manuelle Befundung der Leiterplatte L durch einen Operator O, bspw. über die Rückführstrecke, ist dann nicht erforderlich. Weiterhin entfällt der Pflegeaufwand der Prüfprogramme in einem Softwaremodul, vgl. Softwaremodul SWM1 weiter unten, zu optischen Bildverarbeitung OR, der bspw. aufgrund Änderungen der Lichtverhältnisse oder Änderungen in der der Zusammensetzung der Leiterplatte durch den Leiterplattenhersteller erforderlich ist.

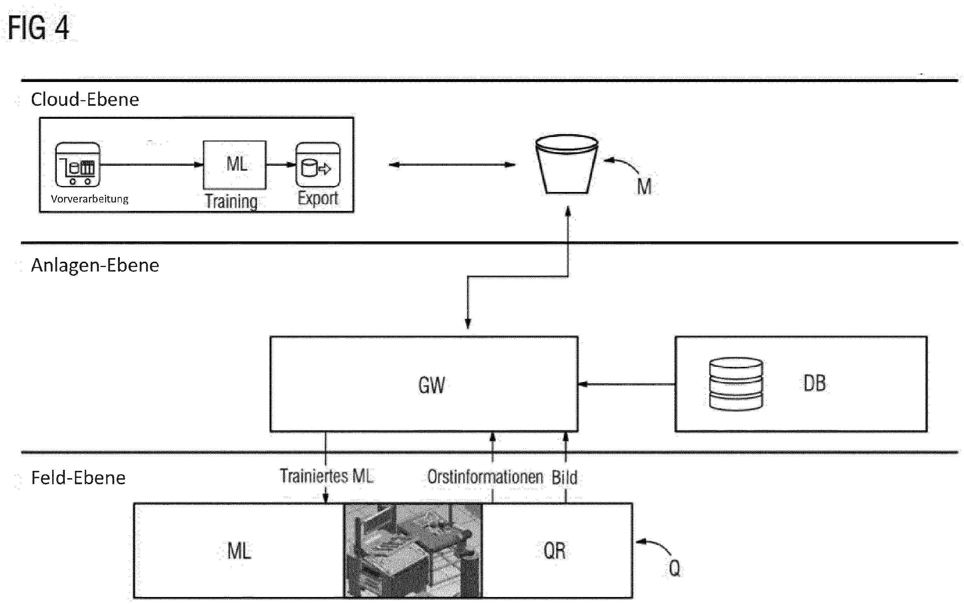

Die Anpassung, auch Training genannt, eines lernfähigen Algorithmus ML erfolgt in einer Trainingsphase (vgl. u.a. FIG 4 und FIG 5 und 6), in welcher der lernfähige Algorithmus ML Bilder P1 der Leiterplatte L als Input erhält und interne Parameter verändert. Der lernfähige Algorithmus ML startet also bspw. in einem Zustand, in dem er ein Problem, hier die Qualitätskontrolle der Leiterplatte(n), nur unzufriedenstellend löst. Durch das Training wird der lernfähige Algorithmus ML auf die Aufgabe spezialisiert. Erst nach dem Training beherrscht der lernfähige Algorithmus die gestellte Aufgabe, z.B. hier die Klassifizierung eines Bildes bzw. zugehörige Bilddaten in eine oder mehrere (Fehler-)Klassen, was Data Scientists als "Prediction" bezeichnen.

Zur Qualitätskontrolle der Leiterplatte L anhand eines von der Leiterplatte erfassten Bildes, bzw. der zugehörigen Bilddaten, die bspw. in Form einer Datei vorliegen, kann ein Fehlerindikator F1, F2, F3 eingesetzt werden. Ein Fehlerindikator F1, F2, F3 kann einen fehlerhaften oder fehlerfreien Zustand einer Leiterplatte L indizieren. Bspw. kann vermittels der optischen Bildverarbeitung OR ein erster Fehlerindikator F1 und vermittels des lernfähigen Algorithmus ein zweiter Fehlerindikator F2 bestimmt werden. Ferner ist es möglich durch die Befundung einer Leiterplatte L (bspw. durch den Operator O) einen dritten Fehlerindikator zu bestimmen.

Dazu können Fehlerkategorien und entsprechende Fehlerklassen vorgesehen sein. Bspw. kann ein Fehlerindikator F1, F2, F3 mehrere unterschiedliche fehlerhafte Zustände, d.h. Fehler, einer Leiterplatte L indizieren. Mögliche Fehler bei der Fertigung einer Leiterplatte L sind zum Beispiel:
Lotpaste fehlt oder ist unvollständig gedruckt,
Lotpaste verschmiert, Kleber fehlt oder ist unvollständig gedruckt, Kleber verschmiert, Bauteil fehlt, Bauteil versetzt oder verdreht, Grabsteineffekt, Bauteil vertauscht, Farbringerkennung bei MELF-Bauteilen, Verwechslungsprüfung für IC/µC-Typen, Verwechslungsprüfung für Widerstandswert, Bauteil verpolt (IC, Diode), Kurzschlüsse und Lotbrücken (IC, µC, Lötstelle fehlt, offene THT-Lötstelle, THT-Lötstelle ohne Durchkontaktierung. Ein Wert des Fehlerindikators F1, F2, F3 kann somit den erkannten Fehler, auch Fehlerkategorie genannt, indizieren. Der Wert des Fehlerindikators kann aus einer alphanumerischen Ziffernkette bestehen oder eine solche umfassen. Ferner kann der Fehlerindikator den Fehler in Klartext, s.o., beschreiben oder diesen codiert beinhalten.

Der lernfähige Algorithmus ML erhält, wie beschrieben, ein Bild bzw. ein oder mehrere Bildbereiche als Input und assoziiert das Bild bzw. den oder die Bildbereiche zu einer der Fehlerkategorien bzw. zu einer der Fehlerkategorie entsprechenden Klasse. Eine Fehlerklasse kann somit einen oder mehrere der o.g. Fehler repräsentieren. Wie bereits erwähnt kann der Fehlerindikator auch einen Wert annehmen, der einen fehlerfreien Zustand der Leiterplatte L indiziert.

Ein oder mehrere Fehler, die von der optischen Bildverarbeitung OR erkannt werden, können dem lernfähigen Algorithmus ML übermittelt werden. Hierzu erwartet der lernfähige Algorithmus ML ein Bild, bspw. in Form von Bilddaten, vorzugsweise in Form einer (Bild)Datei, und vorzugsweise die Ortsinformation in welchem Bildbereich sich der oder die Fehler laut der optischen Bildverarbeitung OR befinden. Der lernfähige Algorithmus ML bewertet dann erneut jedes das Bild bzw. jeden Bildbereich sequentiell. Wenn alle Bilder bzw. Bildbereiche bewertet wurden, stellt der lernfähige Algorithmus ML das Ergebnis für jeden Bildbereich, bspw. an einer Übergabestelle der optischen Bildverarbeitung OR, bereit. Die Ergebnisse des lernfähigen Algorithmus ML können nun verwendet werden, um die Auswertung der optischen Bildverarbeitung zu überschreiben. Von Vorteil ist dabei eine Reduktion des Programmieraufwands der optischen Bildverarbeitung OR und eine Erhöhung des First-Pass-Yields, da der lernfähige Algorithmus ML, der sich bspw. ebenfalls auf dem Inspektionssystem Q befindet, die Bewertung der Lötstellen durch die optische Bildverarbeitung OR korrigiert.

Wie in FIG 2 gezeigt kann dann anstatt des ersten Fehlerindikators F1, der von der optischen Bildverarbeitung bestimmt wurde, der zweite Fehlerindikator F2, der von dem lernfähigen Algorithmus ML bestimmt wurde, ausgegeben werden. Dazu kann wie oben beschrieben eine Anzeigeeinheit wie eine Lichtsignalanlage vorgesehen sein, die ein erstes Lichtsignal, wie bspw. rot, anzeigt, falls (auch) vermittels des Inspektionssystems Q, insbesondere vermittels des lernfähigen Algorithmus ML, ein Fehler bestimmt wurde, bzw. ein zweites Lichtsignal anzeigt, falls kein Fehler erkannt wurde, d.h. der zweite Fehlerindikator F2 keinen Fehler indiziert.

In einer Datenbank DB kann ein Ergebnis einer Befundung durch einen Operator O abgespeichert werden. Dabei kann ein dritter Fehlerindikator F3 verwendet werden, der ebenfalls wie beschrieben eine oder mehrere Fehlerkategorien (und natürlich auch einen fehlerfreien Zustand einer Leiterplatte L) repräsentieren kann. Der dritte Fehlerindikator F3 kann dann zum (Nach)Trainieren des lernfähigen Algorithmus ML verwendet werden.

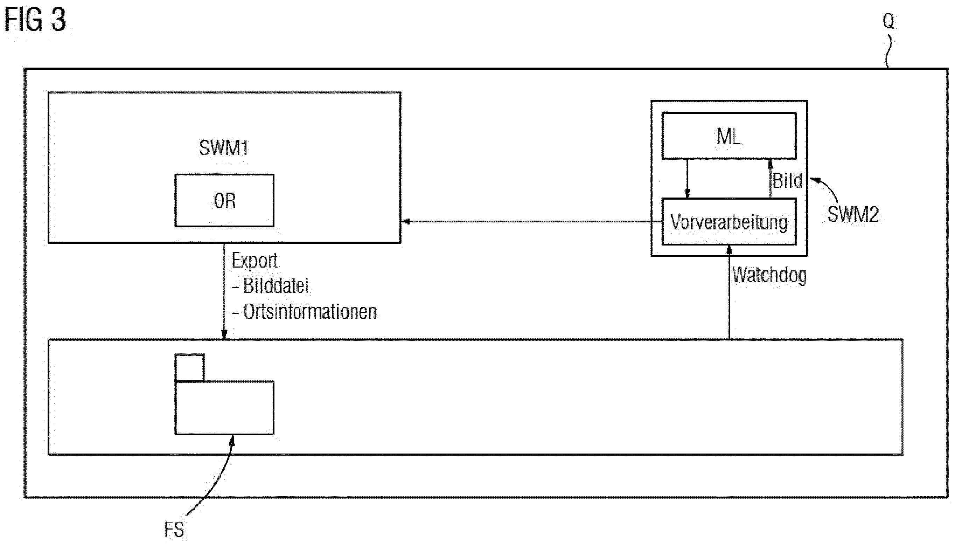

FIG 3 zeigt eine schematische Darstellung eines Ablaufs einer Bildverarbeitung und Fehlerindikatorbestimmung zur Qualitätskontrolle während der Leiterplattenfertigung. Die optische Bildverarbeitung OR und der lernfähige Algorithmus ML sind dabei in einem ersten bzw. einem zweiten Softwaremodul SWM1, SWM2 implementiert. Es kann jedoch auch der Fall vorliegen, dass sowohl die optische Bildverarbeitung OR und der lernfähige Algorithmus ML in einem (einzigen) Softwaremodul implementiert sind. Das oder die Softwaremodule können dabei in dem Inspektionssystem Q gespeichert und/oder von dem Inspektionssystem Q ausgeführt werden.

Vorliegend wird zunächst mittels eines ersten Softwaremoduls SWM1 ein erster Fehlerindikator F1 bestimmt. Der Fehlerindikator F1 sowie das erfasste Bild werden dann in einem Speicher FS, wie bspw. einem geteilten Dateisystem, gespeichert. Zusätzlich zu dem erfassten Bild P1 können Ortsinformationen, die angeben, in welchem Bildbereich sich der oder die Fehler befinden, in dem Speicher FS gespeichert werden. Der Speicher FS kann sich dabei ebenfalls auf dem Inspektionssystem Q befinden.

Alle Fehler, die von der optischen Bildverarbeitung OR detektiert werden, werden dem lernfähigen Algorithmus ML, bspw. in Form eines oder mehrerer erster Fehlerindikatoren F1, übergeben. Das zweite Softwaremodul SWM2 kann bspw. das erfasste Bild P1 und die Ortsinformation, in welchem Bildbereich sich der oder die Fehler laut der optischen Bildverarbeitung OR befinden, aus dem Speicher FS abrufen. Der lernfähige Algorithmus ML bewertet dann das übergebene Bild bzw. jeden übergebenen Bildbereich. Der Speicher FS kann, bspw. durch einen Watchdog, überwacht werden, so dass sobald ein neues Bild bzw. eine neue Bilddatei vorliegt, die Verarbeitung durch das zweite Softwaremodul SWM2 bzw. den lernfähigen Algorithmus ML begonnen werden kann.

Ferner kann es erforderlich sein, dass bevor der lernfähige Algorithmus ML ein Bild P1 bzw. Bildbereich verarbeitet, eine Vorverarbeitung des Bildes des Bildbereichs erfolgen muss. Diese Vorverarbeitung, wie bspw. das Skalieren und Padding des Bildes bzw. des Bildbereichs kann ebenfalls vermittels des zweiten Softwaremoduls SWM2 erfolgen. Alternativ kann ein separates Softwaremodul, das diese Vorverarbeitung, auch "Data Prep" genannt, durchgeführt vorgesehen sein.

Wenn eine Bild bzw. die ein oder mehrere Bildbereiche vermittels des lernfähigen Algorithmus ML in bewertet wurden, stellt das zweite Softwaremodul SWM2 das Ergebnis für das Bild bzw. jeden Bildbereich an einer Übergabestelle der ersten Softwaremoduls SWM1 bspw. in Form eines zweiten Fehlerindikators F2 bereit. Eine Ausgabe des zweiten Fehlerindikators F2, der durch den lernfähigen Algorithmus ML bestimmt wurde, kann alternativ oder zusätzlich vermittels des zweiten Softwaremoduls SWM2 erfolgen. Alternativ kann ein separates Softwaremodul, das die Ergebnisverarbeitung durchgeführt, vorgesehen sein. Bspw. kann der zweite Fehlerindikator ebenfalls in den Speicher FS, wie bspw. das genannte geteilte Dateisystem, abspeichern.

Das erste Softwaremodul SWM1 kann nun das Ergebnis in Form eines oder mehrerer zweiter Fehlerindikatoren F2 des lernfähigen Algorithmus ML verwenden, um die Auswertung der optischen Bildverarbeitung OR zu überschreiben bzw. das Ergebnis des lernfähigen Algorithmus ML auszugeben, d.h. anstatt des Ergebnisses in Form eines oder mehrerer erster Fehlerindikatoren F1 der optischen Bildverarbeitung OR.

FIG 4 zeigt eine schematische Darstellung eines Ablaufs zum (Nach-)Trainieren eines lernfähigen Algorithmus ML basierend auf einem Datensatz bspw. mit Bilddaten, Ortsinformationen und Befundungsinformationen.

Für das Anlernen bzw. Nachlernen, auch Trainieren bzw. Nachtrainieren genannt, des lernfähigen Algorithmus ML werden Bilder von vermittels der Bildverarbeitung OR durch einen ersten Fehlerindikator F1 als fehlerhaft indizierten Leiterplatten sowie vorzugsweise die Ortsinformation der vermittels der Bildverarbeitung OR detektierten Fehler abgegriffen und bspw., wie in FIG 4 gezeigt, in einer Cloud, bspw. in dem in FIG 4 gezeigten Speicher M, abgelegt.

Zu diesem Zweck kann das Inspektionssystem Q mit einem Gateway GW verbunden sein, welches Gateway eine Verbindung zwischen der Cloud und dem Inspektionssystem Q herstellt. Zudem können die Informationen aus der manuellen Befundung des Operators aus der Qualitätsdatenbank DB in dem Speicher M gespeichert werden. Zu diesem Zweck kann auch die Datenbank DB mit dem Gateway GW verbunden sein. Die Befundungsinformationen, die bspw. in der Dantebank DB gespeichert sind, repräsentieren das Wissen des Operators O, der mit der Befundung der von der Bilderkennung OR als fehlerhaft indizierten Leiterplatte(n) befasst war. Diese Befundungsinformationen werden genutzt, um die Bilder der Leiterplatte(n)zu labeln. D.h. das von einer Leiterplatte erfasst Bild und die Ortsinformationen eines von der Bilderfassung bestimmten Fehlers werden mit den Befundungsinformationen verknüpft und ggf. in dem Speicher M in der Cloud gespeichert. In der Cloud kann der lernfähige Algorithmus ML dann basierend auf diesen mit den Befundungsinformationen gelabelten Daten trainiert werden. Die mit den Befundungsinformationen gelabelten Bilder bilden dann die sog. "Ground Truth" für den lernfähigen Algorithmus. Ggf. erfolgt auch in der Cloud zunächst eine Vorverarbeitung "Data Prep" der empfangenen bzw. gespeicherten Bilder. Diese Vorverarbeitung kann bspw. Padding und Augmentieren der Bilder bzw. Bilddaten umfassen, wie weiter unten noch erläutert wird.

Der lernfähige Algorithmus kann nach Abschluss des Trainings, bspw. anhand der "Ground Truth" - also auf Basis mit Befundungsinformationen gelabelten Bilder bzw. Bilddaten, ein Bild einer Leiterplatte bewerten. Die Befundungsinformationen können dabei in Form eines dritten Fehlerindikators F3 vorliegen.

Nach dem Training kann der trainierte lernfähige Algorithmus ML exportiert werden, vgl. "Export" in FIG 4. Der trainierte lernfähige Algorithmus ML kann dann an das Inspektionssystem Q übertragen werden. Ein in dem Inspektionssystem Q bereits vorhandener lernfähiger Algorithmus ML kann so durch den neu trainierten lernfähigen Algorithmus ML aktualisiert werden. Dadurch kann der lernfähige Algorithmus ML angepasst werden. Bspw. können bei Vorliegen einer vorgegebenen Anzahl an erfassten Bildern und/oder bei Vorliegen einer vorgegebenen Anzahl an Befundungsinformationen eine Aktualisierung des lernfähigen Algorithmus auf dem Inspektionssystem Q vorgenommen werden. Die Befundungsinformationen entsprechen dabei bspw. dem dritten Fehlerindikator, dessen Wert durch einen Operator bei der Befundung festgelegt wurde.

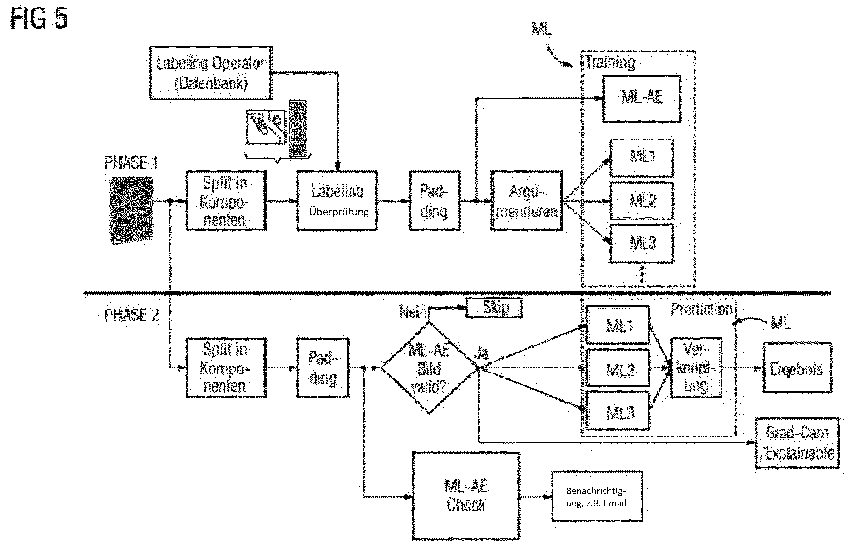

FIG 5 zeigt eine schematische Darstellung eines ersten Ablaufs einer Bildverarbeitung für das Trainieren (Phase 1) und während des Einsatzes eines lernfähigen Algorithmus ML (Phase 2) .

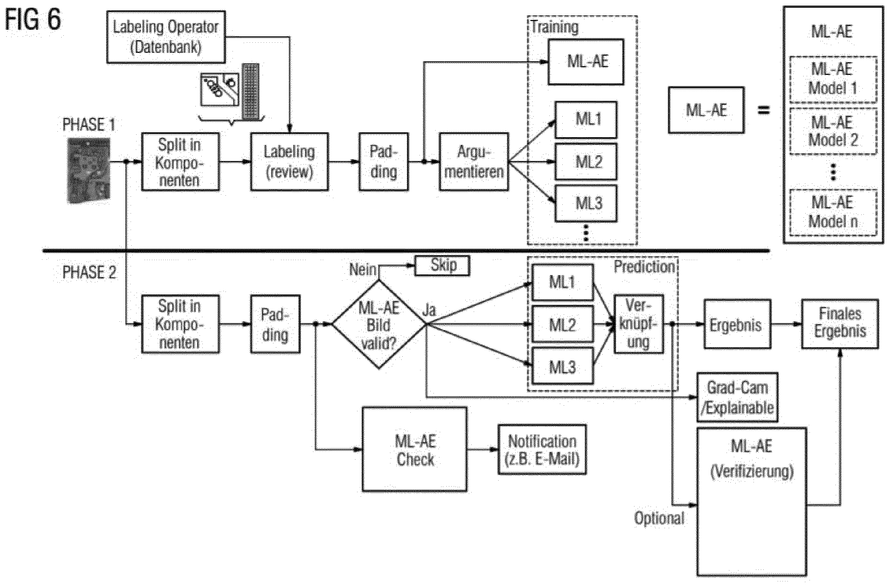

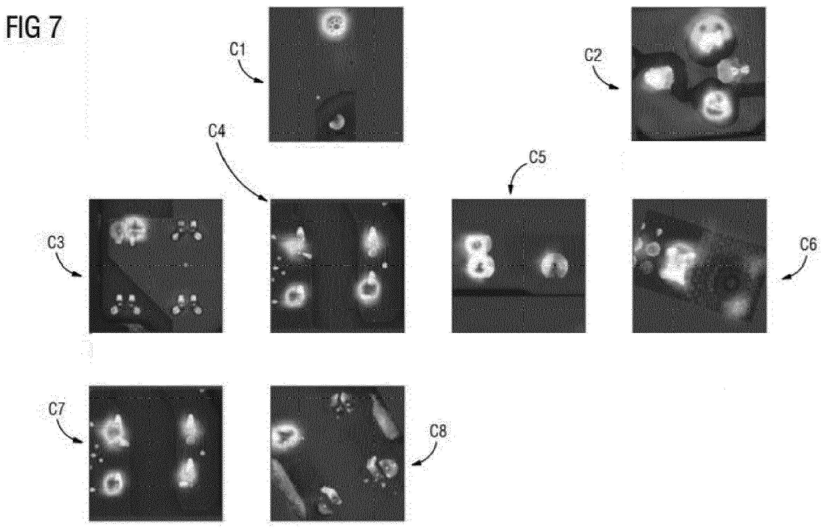

Um Ergebnisse von dem lernfähigen Algorithmus ML zu erhalten, werden verschiedene Phasen und Schritte durchlaufen, welche nachfolgend erläutert werden. Als Basis dient ein von der zu untersuchenden Leiterplatte L erfasstes Bild P1. Dieses Bild P1 kann in verschiedene sogenannte Bildbereiche, vgl. Bildbereiche C1,...,C8 in FIG 7, aufgeteilt werden. Dies ist in den FIG 5 und 6 als "Split in Komponenten" bezeichnet.

In Phase 1 (Trainingsphase) ist es notwendig, dass das Bild bzw. die Bildbereiche in die vorhandenen und definierten Fehlerkategorien zugeordnet werden. Es existieren verschiedene Werte eines Fehlerindikators, die einen fehlerhaften bzw. einen fehlerfreien Zustand der Leiterplatte L indizieren. Diese Zuordnung oder auch "Labeling" genannt, erfolgt manuell und mittels menschlicher Expertise, bspw. vermittels der in der Datenbank DB gespeicherten Bilder und der zugehörigen Fehlerindikatoren, die durch die Befundung durch einen Operator erzeugt wurden. Wenn ein Bild bspw. einen gewissen Fehler A enthält (z.B. Pin-Kurzschluss), wird dieses mit dem Label A versehen. Somit ergeben sich diverse Gruppen von Bildern. Diese Bilder(gruppen) werden als Ground-Truth-Daten bezeichnet und dienen als Basis für die weiteren Trainings-Schritte.

Der Labeling-Prozess kann zwei Stufen umfassen: Der Opertor O macht ein Pre-Labeling der Daten und speichert diese Informationen in der Datenbank DB. Zusätzlich kann eine Überprüfung des vorgenommenen Labeling vorgenommen werden und das Pre-Labeling gegebenenfalls überschrieben werden. In FIG 5 durch "Labeling review" durch den "Labeling Operator (Datenbank)" dargestellt.

Aufgrund der unterschiedlichen Größe der einzelnen Bilder bzw. Bildbereiche, ist es im nächsten Schritt notwendig, die Bilder bzw. Bildbereiche auf eine einheitliche Größe zu bringen. Die unterschiedliche Größe der Bilder bzw. Bildbereiche ist physikalisch bedingt, da die Bildbereiche unterschiedliche elektronische Bauteile bzw. Prüfbereiche mit einer oder mehreren Lötstellen beinhalten. Bspw. kann eine einheitliche Bildgröße zur Verarbeitung definiert werden. Bspw. kann eine quadratische Größe definiert (beispielswiese 512 mal 512 Pixel gewählt werden. Die einheitliche Bildgröße kann konfigurierbar sein, so dass sie, bspw. an verschiedene Prüfbereiche auf einer Leiterplatte und also verschiedene Leiterplattentypen, anpassbar ist. Um eine Skalierung auf eine einheitliche Bildgröße zu erreichen, findet bspw. ein "Up-Down-Sampling" statt und es können künstliche Pixel erzeugt und künstlichen Pixelwerten aufgefüllt werden. Dies wird auch als Padding bezeichnet. Hat zum Beispiel eine Bildbereich eine ursprüngliche Größe von 200 mal 600 Pixel, werden künstliche Pixelwerte erzeugt und an das Bild angehängt, um bspw. eine quadratische Größe zu erhalten. Die erzeugten künstlichen Pixelwerte können zufällig aus einer generierten Farb-Verteilung, bspw. zulässigen RGB-Werten, generiert werden. Die Farb-Verteilung aus denen die Pixelwerte für die künstlichen Pixel erzeugt werden, kann bspw. durch Intervalle in dem RGB-Farbraum gegeben sein. Die Farb-Verteilung ist dabei anpassbar und sollte in einer ähnlichen Farb-Verteilung liegen, wie die Grundfarbe der Leiterplatten. Bspw. kann ein künstlicher Pixelwert, bspw. zufällig, aus einem Intervall für den Rotkanal, bspw. [37, 42], einem Intervall für den Grünkanal, bspw. [63, 73], und einem Intervall für den Blaukanal, bspw. [36, 41], ausgewählt werden. Die Randwerte des jeweiligen Intervalls oder Farb-Verteilung allgemein können anhand der Minimalwerte und/oder Maximalwerte von erfassten Bildern von unterschiedlichen Leiterplatten, bspw. dem o.g. Ground Truth Datensatz, bestimmt werden. Die generierte Farb-Verteilung bzw. die Farb-Bereiche aus denen die künstlichen Pixelwerte für das Padding ausgewählt werden, können den Farbwerten der Leiterplatten aus einem Datensatz von Bildern der Leiterplatte, bspw. aus der Leiterplattenfertigung in der Anlage, entsprechen.

Im Anschluss an das Padding, kann eine Augmentierung der Bilder bzw. Bildbereich erfolgen. Alternativ kann auch zuerst das Augmentieren erfolgen. Das Augmentieren ist ein Verfahren, um den ursprünglichen Datensatz an Bildern anzureichern, um eine möglichst hohe Varianz zu erzeugen und den Einfluss von Rauschen und leichten Veränderungen von neuen echten Bildern zu minimieren. Die Bilder bzw. Bildbereiche werden zufällig rotiert, gedreht, gespiegelt und/oder einzelne RGB-Farbkanäle werden geändert und/oder die Helligkeit der Bilder bzw. Bildbereiche wird dazu variiert. Es entsteht somit eine Vielzahl an neuen, synthetischen Bildern bzw. Bildbereichen. Dieser Schritt ist für das Trainieren des lernfähigen Algorithmus vorteilhaft und führt zu einer Verbesserung der Klassifizierung des lernfähigen Algorithmus ML.

Im nächsten Schritt wird der lernfähige Algorithmus ML, vorzugsweise anhand des augmentierten Datensatzes an Bildern bzw. Bildbereichen, trainiert. Der lernfähige Algorithmus kann bspw. zwei Teilen umfassen: Der erste Teil besteht aus sehr vielen sogenannten Convolution (Faltungs-)Schichten mit sehr vielen Parametern und der zweite Teil besteht aus einem fully-conntected neuronalen Netzwerk, mit weniger Parametern. Das Training kann dann in zwei Schritten stattfinden. Zunächst findet ein Transfer-Learning statt. Dies bedeutet, dass der erste Teil des lernfähigen Algorithmus (Convolution-Schichten) auf einem bekannten und großen Datenset vortrainiert wurde. Vorzugsweise wird nur der zweite Teil (fully-conntected Netzwerk) trainiert (d.h. die Parameter des Netzwerkes werden optimiert mit speziellen und bekannten Optimierungsverfahren). Im Anschluss kann ein "Fine-tuning" erfolgen. Hierbei wird der komplette lernfähige Algorithmus trainiert, vorzugsweise jedoch mit einer geringeren Lernrate (d.h. eine weniger starke Anpassung bzw. Veränderung der Parameter) und einer kürzeren Zeit (weniger Epochen). Nachdem der lernfähige Algorithmus trainiert wurde, ist er dazu in der Lage, neue Bilder zu klassifizieren und kann somit in der "Produktiv-Phase" eingesetzt werden.

Eine mögliche Ausführungsform des lernfähigen Algorithmus ML umfasst das Zusammenschalten unterschiedlicher Modelle ML1, ML2, ML3 mit dem Ziel, das Gesamtergebnisse zu verbessern (sogenanntes Ensemble Learning). Bei den Modellen ML1, ML2, ML3 kann es wiederum um lernfähige Algorithmen handeln. Die Modelle ML1, ML2 bzw. ML3 können wie oben beschrieben zweiteilig ausgeführt sein oder aber ein oder mehrere der Modelle ML1, ML2, ML3 kann einteilig ausgeführt sein. Beim Ensemble Learning werden verschiedene Modelle ML1, ML2, ML3 mit den gleichen Daten trainiert. Die Modelle ML1, ML2, ML3 unterscheiden sich leicht von ihrem Aufbau bzw. Funktionsweise, haben jedoch das gleiche Ziel: Klassifizierung der Leiterplatten entsprechend den Fehlerkategorien bzw. Fehlerklassen. Bspw. weisen die Modelle ML1, ML2, ML3 unterschiedliche Modelarchitekturen und/oder unterschiedliche Hyperparameter bzw. Werte der Hyperparameter auf. Die Ausgaben der einzelnen Modelle ML1, ML2, ML3 werden miteinander verknüpft, um das Gesamtergebnisse zu verbessern. Bei beispielsweise drei Modellen, wird das End-Ergebnisse nur genutzt, wenn zwei der drei Modelle übereinstimmen. Dadurch wird ein höheres Vertrauen erzielt, da man nicht nur auf das Ergebnis eines einzelnen Modelles ML1, ML2, ML3 vertraut.

Zusätzlich und/oder alternativ zu den Modellen ML1, ML2, ML3 kann ein Autoencoder ML-AE oder kurz AE trainiert werden, der dazu dient, das als Input erhaltene Bild bzw. den Bildbereich zu rekonstruieren. Der Autoencoder AE kann später im produktiven Betrieb in "Phase 2" dazu dienen, ein oder mehrere neu erfasste Bilder bzw. Bildbereiche der Leiterplatte daraufhin zu prüfen, ob diese ähnlich zu den Bildern sind, auf denen basierend der lernfähige Algorithmus, bzw. insbesondere die Modelle ML1, ML2, ML3 des lernfähigen Algorithmus, trainiert wurde. Überschreitet ein Rekonstruktionsfehler des Autoencoders AE bspw. einen vorgegebenen Schwellenwert, so kann dies als Hinweis auf eine möglicherweise fehlerhafte Klassifikation des lernfähigen Algorithmus dienen. Wie in Phase 2 als "ML-AE Check" dargestellt, kann dann eine Benachrichtigung, d.h. "Notification", per E-Mail erfolgen.

### Phase 2 ("Produktiv-Phase"):

Der lernfähige Algorithmus ML kann bspw. einen Autoencoder ML-AE oder kurz AE umfassen. Der Autoencoder AE kann wie beschrieben mit den Ground-Truth-Daten in Phase 1 trainiert werden, um eine Validierung von einem oder mehreren neuen Bildern einer oder mehrerer Leiterplatten vorzunehmen und falls diese nicht valide sind, bspw. in einen dafür bestimmtes Verzeichnis, bspw. in einem Speicher auf dem Inspektionssystem oder einer Datenbank, abgelegt werden und insbesondere nicht für die Vorhersage eines Fehlerindikators durch den lernfähigen Algorithmus genutzt werden. Ferner kann der Autoencoder AE dazu genutzt werden, eine Überwachung der neuen Daten (Datenverteilung) um einen Drift in den (Bild)Daten zu erkennen. Ein Drift würde bedeutet, dass sich in den Bildern irgendetwas verändert hat und ggf. eine Korrektur oder anderweitiger Eingriff in erforderlich ist. Dies erfordert eine Überwachung über die Zeit der neuen Bilder mittels des Autoencoders AE. Als Kennwert für einen Drift der neuen Bilder kann ein Rekonstruktionsfehler des Autoencoders AE verwendet werden.

Das Ergebnis des lernfähigen Algorithmus ML kann über eine Gewichtung der Ergebnisse der Modelle ML1, Ml2, ML3 erfolgen. Das Ergebnis des lernfähigen Algorithmus ML kann in Form eines (zweiten) Fehlerindikators F2 ausgegeben werden. Ausgeben, bedeutet hierbei bspw. in einem Speicher, wie z.B. in einer Datei, gespeichert oder bspw. auf einer Anzeigeeinheit wiedergegeben werden.

Zusätzlich kann, wie in FIG 7 gezeigt, eine Heatmap bzw. Grad-CAM (Gradient Class Activation Map) der Klassenvorhersage des Autoencoders AE ausgegeben bzw. angezeigt werden.

FIG 6 zeigt eine schematische Darstellung eines zweiten Ablaufs einer Bildverarbeitung für das Trainieren und während des Einsatzes eines lernfähigen Algorithmus ML. Dieser in FIG 6 gezeigte Ablauf ist größtenteils demjenigen in FIG 5 gleich und unterscheidet sich nur in folgenden Merkmalen.

Eine zusätzliche Evaluierung des Klassifikationsergebnisses des lernfähigen Algorithmus ML kann erfolgen, indem ein Autoencoder ML-AE Model 1, Model 2, ..., Model n pro Fehlerkategorie bzw. entsprechender Fehlerklasse (auf Basis der Ground-Truth-Daten) trainiert wird. Nach der Klassifikation durch den lernfähigen Algorithmus ML, wird das entsprechende Bild von allen vorhanden Autoencoder-Modellen ML-AE Model 1, Model 2, ..., Model n vorhergesagt und das Modell mit dem geringsten Fehler (Rekonstruktionsfehler) entspricht der Fehlerklasse (dieser Schritt ist optional). Dadurch kann das Ergebnis des lernfähigen Algorithmus ML verifiziert werden und ggf. das Ergebnis des lernfähigen Algorithmus in ein "Finales Ergebnis", das bspw. demjenigen des Autoencoders ML-AE Model 1, Model 2, ..., Model n mit dem geringsten Fehler entspricht, korrigiert werden.

FIG 7 zeigt mehrere Class Activation Maps C1,...,C8 zur Analyse, welche Teile eines Bildes eine Klassifizierungsentscheidung eines lernfähigen Algorithmus ML beeinflussen. Ein weiterer Bestandteil des lernfähigen Algorithmus kann eine sogenannte Grad-CAM (Gradient Class Activation Map) sein. Dadurch kann gezeigt werden, welche Pixel in dem Bild bzw. Bildbereich für das Klassifikations-Ergebnis des lernfähigen Algorithmus auschlaggebend waren. Beispielsweise werden Bereiche aus dem Bild gekennzeichnet, welche für die Entscheidung des lernfähigen Algorithmus ausschlaggebend waren und diese Bereiche können einem Operator gezeigt werden, damit dieser einerseits ein Feedback über die Funktionsweise des lernfähigen Algorithmus hat und anderseits das Ergebnis des lernfähigen sehr schnell validieren kann.

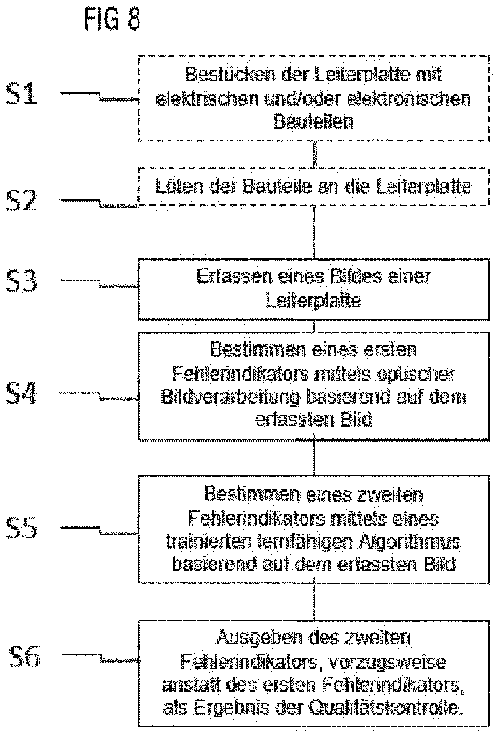

FIG 8 zeigt eine schematische Darstellung eines Verfahrens zur Qualitätskontrolle gemäß einer ersten Ausführungsform.

Dazu wird in einem Schritt S1 eine Leiterplatte mit elektrischen Bauteilen bestückt. In einem darauffolgenden Schritt S2 werden die Bauteile mit der Leiterplatte bspw. durch Löten verbunden.

Löten ist ein thermisches Verfahren zum stoffschlüssigen Fügen von Werkstoffen, wobei eine flüssige Phase durch Schmelzen eines Lotes (Schmelzlöten) oder durch Diffusion an den Grenzflächen (Diffusionslöten) entsteht.

Die Benetzung ist ein wichtiges Kriterium für die erfolgreiche Lötung. Es sollte nur so viel Lot an der Lötstelle verwendet werden, dass die Kontur der Bauteileanschlüsse im Lot sichtbar bleibt. Der Winkel zwischen einem Tropfen des flüssigen Lotes und dem Grundwerkstoff wird Benetzungswinkel genannt. Ein Benetzungswinkel von 0 bis 30° wird als "vollständig bis ausreichend benetzt", von 30 bis 90° als "teilweise benetzt" und über 90° als "nicht benetzt" eingestuft. Grundsätzlich sollte der Benetzungswinkel also kleiner als 30° sein.

Ein weiteres Qualitätsmerkmal ist die Sauberkeit der Lötstellen, so sollten zum Beispiel keine Lotreste außerhalb der Lötstellen zu finden sein. Die Lötstellen sollten sauber und gleichmäßig sein, das gilt auch für die Durchkontaktierungen.

Um ggf. fehlerhafte Lötstellen festzustellen, wird die Leiterplatte einer Qualitätskontrolle unterzogen. Da bei der Leiterplattenfertigung eine Vielzahl an Leiterplatten produziert werden, ist gegebenenfalls eine Qualitätskontrolle aller gelöteten Leiterplatten oder zumindest eines Teils der gelöteten Leierplatten erforderlich. Zum Zweck der Qualitätskontrolle kann in einem Schritt S3 ein Bild einer Leiterplatte erfasst werden. Anhand einer optischen Bildverarbeitung kann basierend auf dem erfassten Bild ein erster Fehlerindikator bestimmt werden.

Die Bilderfassung erfolgt bspw. mit einer Scannereinheit, vorzugsweise umfassend eine Kamera, wie bspw. eine Charge-Coupled Device (CCD)-Zeilenkamera mit Rot-Grün-Blau (RGB)-Farbfilter und besonders bevorzugt einer Beleuchtungseinheit wie bspw. einer Light-Emitting Diode (LED). Die Leiterplattenoberfläche wird hierzu bspw. durch eine Relativbewegung der Scannereinheit und der Leiterplatte erfasst. Die Kamera erzeugt dabei bspw. ein Bild der Leiterplatte mit einer Farbtiefe von 3x8 Bit. Das erfasste Bild ist bspw. mit 8101x5157 Pixeln hochauflösend. Die Bildaufnahme wird mit einem telezentrischen Objektiv durchgeführt. Das bedeutet, dass die von der Leiterplatte reflektierten Strahlen der LED-Beleuchtungseinheit parallel in das Objektiv der CCD-Kamera fallen. Dies führt dazu, dass die Strukturen der Leiterplatte senkrecht zur Linse ohne perspektivische Verzerrung aufgenommen werden. Dadurch wird die Leiterplatte unabhängig von ihrem Abstand zum Objektiv gleich groß abgebildet. Die Scannereinheit weist zudem ein Spiegelsystem zur Verkürzung der Brennweite auf, wobei die Leiterplatte und die Scannereinheit während des Bilderfassungsvorganges in geringem Abstand zueinander angeordnet sind. Durch die Verkürzung der Brennweite ist das System sehr kompakt. Dadurch kann das Inspektionssystem samt Bilderfassung leichter in die Fertigungslinie integriert werden. Weiterhin kann durch die gezielte Beleuchtung eines kleinen Bereichs die Beleuchtungseinheit kleiner dimensioniert werden. Dies spart Energiekosten und sorgt für geringere Erhitzung. Ferner können im Bereich der Kamera günstige Großserienprodukte eingesetzt werden, die meist eine bessere Auflösung bieten als die nur in geringer Stückzahl gefertigten teuren Industriekameras.

Basierend auf dem erfassten Bild kann in einem Schritt S4 mittels optischer Bildverarbeitung ein erster Fehlerindikator bestimmt werden. Nachdem das Bild der Leiterplatte erfasst wurde, wird dieses in einer Bildverarbeitungssoftware, bspw. einem ersten Softwaremodul SWM1, ausgewertet. Dabei kann mit der Bildverarbeitungssoftware der erfasste Istzustand mit den abgespeicherten Sollzuständen verglichen werden und eine prozentuale Abweichung errechnet werden. Hierzu können Prüffelder auf der Leiterplatte festgelegt werden. Diese Prüffelder entsprechen den Bildbereichen, in denen die zu prüfenden Lötstellen liegen. Diese Prüffelder werden auf Bauteilebene festgelegt. Es können mehrere Lötstellen innerhalb eines Prüffeldes liegen. Innerhalb der Prüffelder werden dann die einzelnen Lötstellenkoordinaten definiert. Dadurch kann die Prüfung auf Lötstellenebene durchgeführt werden. Für die Bewertung einer Lötstelle als fehlerhaft oder fehlerfrei mittels eines ersten Fehlerindikators werden sodann bspw. die RGB-Werte innerhalb des Prüfbereichs ausgelesen. Nun kann mithilfe von diversen Filtern beispielsweise der Mittelwert der RGB-Werte eines Bildpunkts auf der Lötstelle berechnet werden. Diese Filter werden auf alle Bildpunkte auf der Lötstelle angewandt. Nach dieser Operation ist jedem Pixel ein RGB-Wert zugeordnet. Nachfolgend wird ein RGB-Schwellenwert festgelegt. Anhand dieses Schwellenwertes können die Pixel oberhalb und unterhalb davon kategorisiert werden. Nun können die Pixel gezählt werden, die entweder oberhalb oder unterhalb des definierten Schwellenwertes liegen. Nach diesem Schritt liegt je eine Summe vor, die die Anzahl von Pixeln beschreibt, die den Schwellenwert überschreiten und unterschreiten. Im letzten Schritt der Prüfung mittels optischer Bildverarbeitung wird ein zweiter Schwellenwert für die Summe der Pixel definiert. Über- oder Unterschreitet die zuvor gebildete Summe von Pixeln den zweiten Schwellenwert, so fällt die Lötstelle aus.

Die Definition der Prüffelder und der Lötstellenkoordinaten kann von Anwender erstellt werden und wird in einem oder mehreren Prüfplänen gespeichert. Bspw. kann für jede Produktvariante ein Prüfplan erstellt werden, der dann skalierbar im Inspektionssystem und der optischen Bildverarbeitung eingesetzt werden kann. Die Referenz zur richtigen Positionierung der Leiterplatte kann anhand von Passermarken auf der Leiterplatte erfolgen, die durch die Bildverarbeitung erkannt werden und das Koordinatensystem anlegen. Dadurch sind die Lötstellenkoordinaten auch tatsächlich dort, wo die Lötstellen zu erwarten sind. Der Ursprung des Koordinatensystems kann bspw. in der oberen linken Ecke des Bildes festgelegt werden.

Als Ergebnis des Schrittes S4 steht somit ein erster Fehlerindikator, der angibt, ob anhand der optischen Bildverarbeitung eine fehlerhafte oder fehlerfreie Leiterplatte erkannt wurde.

Dieser Fehlerindikator kann zusammen mit dem erfassten Bild und ggf. weiteren Informationen wie bspw. Ortsinformationen zu der als fehlerhaft erkannten Lötstelle auf der Leiterplatte gespeichert werden. Bspw. kann dazu wie bereits beschrieben ein Speicher, bspw. ein geteiltes Dateisystem, genutzt werden.

In einem Schritt S5 kann basierend auf dem erfassten Bild bzw. Bildbereich ein zweiter Fehlerindikator mittels eines trainierten lernfähigen Algorithmus bestimmt werden. Dazu kann das erfasste Bild bzw. der Bildbereich als Input für einen trainierten lernfähigen Algorithmus dienen. Der trainierte lernfähige Algorithmus klassifiziert das Bild bzw. den Bildbereich entsprechend den Fehlerklassen des Fehlerindikators und gibt diese Klassifikation als zweiten Fehlerindikator aus.

Dabei kann der erste Fehlerindikator die gleiche bzw. entsprechende Fehlerklassen bzw. Fehlerkategorien aufweisen wie der zweite Fehlerindikator. Außerdem ist es möglich das die Fehlerklassen des ersten Fehlerindikators eine Teilmenge der Fehlerklassen des zweiten Fehlerindikators ist, d.h. dass also der zweite Fehlerindikator zusätzlich Fehlerklassen aufweist, die vom ersten Fehlerindikator nicht angenommen werden können. Zudem besteht die Möglichkeit, dass der erste Fehlerindikator eine oder mehrere Fehlerklassen aufweist, die vom zweiten Fehlerindikator nicht angenommen werden können, die der zweite Fehlerindikator also nicht aufweist. Das gleiche gilt für den dritten Fehlerindikator.

In einem Schritt S6 kann der zweite Fehlerindikator, vorzugsweise anstatt des ersten Fehlerindikators, als Ergebnis der Qualitätskontrolle ausgegeben werden. Nachdem der erste und der zweite Fehlerindikator vorliegen, kann das Inspektionssystem den ersten und/oder zweiten Fehlerindikator ausgeben.

Bevorzugt wird nur der zweite Fehlerindikator ausgegeben. Bspw. kann der Fall vorliegen, dass die optische Bildverarbeitung des Inspektionssystems eine Leiterplatte irrtümlich als fehlerhaft indiziert, und der (trainierte) lernfähige Algorithmus die Leiterplatte als fehlerfrei indiziert. In diesem Fall soll dann als Ergebnis der Qualitätskontrolle, das Ergebnis des lernfähigen Algorithmus verwendet werden, um eine (ansonsten erforderliche) Nachkontrolle der Leiterplatte zu vermeiden. Für den Fall, dass auch der lernfähige Algorithmus eine fehlerhafte Leiterplatte erkennt, wird eine Nachkontrolle der Leiterplatte erforderlich.

In dem Fall, dass die optische Bildverarbeitung eine Leiterplatte als nicht fehlerhaft bestimmt, wird der lernfähige Algorithmus vorzugsweise nicht ausgeführt. Die Leiterplatte kann sodann weiter gefertigt werden, oder zur Auslieferung oder Einbau in ein Gerät verwendet werden. Auch eine Befundung durch einen Operator ist dann nicht erforderlich.

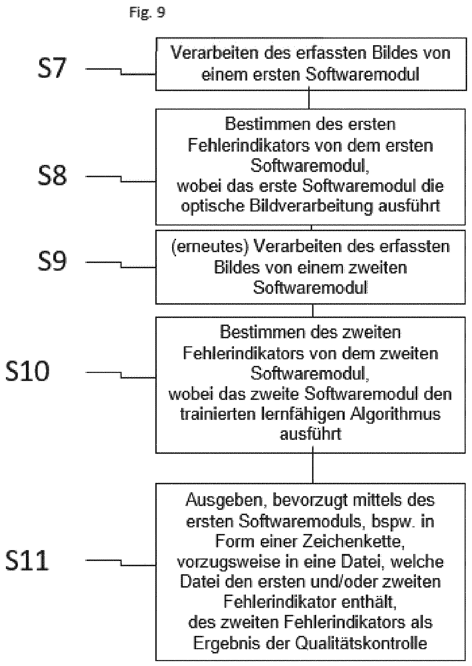

In FIG 9 ist eine schematische Darstellung eines Verfahrens zur Qualitätskontrolle gemäß einer zweiten Ausführungsform gezeigt. Dabei wird das von einer Leiterplatte, bspw. im Schritt S3, erfasste Bild von einem ersten Softwaremodul verarbeitet. Vermittels des ersten Softwaremoduls wird der erste Fehlerindikator bestimmt. Dabei wird vermittels des ersten Softwaremoduls auch die optische Bildverarbeitung ausgeführt. Das erste Softwaremodul kann weiter hier nicht beschriebene Funktionen ausführen.

In einem darauffolgenden Schritt S9 erfolgt dann ein (erneutes) Verarbeiten des erfassten Bildes von einem zweiten Softwaremodul. Dadurch kann der zweiten Fehlerindikator in einem Schritt S10 von dem zweiten Softwaremodul bestimmt werden. Dabei kann das zweite Softwaremodul den trainierten lernfähigen Algorithmus ausführen.

Das erste und das zweite Softwaremodul können auch in ein einziges Softwaremodul zusammengefasst sein. Das erste und zweite Softwaremodul kann, bspw. in einem Speicher, auf dem Inspektionssystem gespeichert und/oder, bspw. von einem oder mehreren Prozessoren, des Inspektionssystems ausgeführt werden.

In einem Schritt S11 kann dann, bevorzugt mittels des ersten Softwaremoduls, bspw. in Form einer Zeichenkette, vorzugsweise in eine Datei, welche Datei den ersten und/oder zweiten Fehlerindikator enthält, der zweite Fehlerindikator als Ergebnis der Qualitätskontrolle ausgegeben werden. Zusätzlich oder alternativ kann der zweite Fehlerindikator bspw. angezeigt werden. In FIG 1 und FIG 2 ist bspw. eine Anzeigeeinheit F1 bzw. F2 vorgesehen, über die das Ergebnis der Qualitätskontrolle, bspw. für einen Operator sichtbar, angezeigt werden kann.

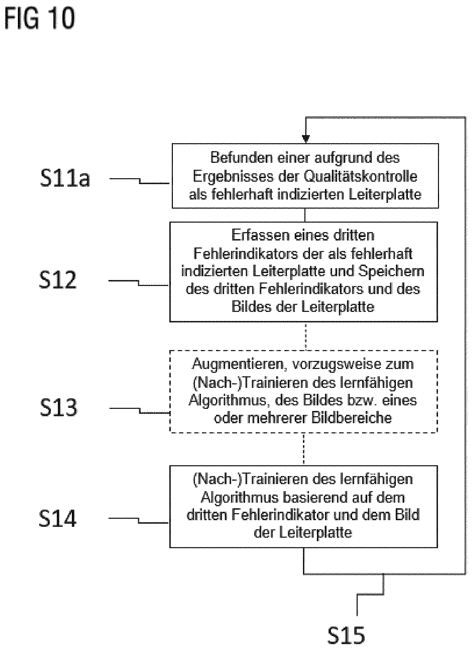

FIG 10 zeigt eine schematische Darstellung eines Verfahrens zum Trainieren eines lernfähigen Algorithmus gemäß einer dritten Ausführungsform.

Hier kann in einem ersten Schritt Slla eine aufgrund des Ergebnisses der Qualitätskontrolle als fehlerhaft indizierten Leiterplatte (manuell) befundet werden. Das Befunden entspricht einer Nachkontrolle der Leiterplatte, bspw. in dem Fall, dass diese von dem Inspektionssystem als fehlerhaft erkannt wurde. Das befunden kann dabei wie beschrieben von einem Operator durchgeführt werden. Der Operator kann das Ergebnis seiner Befundung über eine Befundungstastatur, wie in FIG 1 und 2 gezeigt, eingeben. Dadurch kann in einem Schritt S12 ein dritter Fehlerindikator bestimmt und, bspw. in einer Qualitätsdatenbank, d.h. Datenbank DB in FIG 1, 2 und/oder 4, gespeichert werden. Von einer zunächst als vermittels der optischen Bildverarbeitung als fehlerhaft indizierten Leiterplatte wird also ein weiterer, dritten Fehlerindikators gespeichert. Ferner kann in dem Schritt S12 das Bild der Leiterplatte gespeichert werden. Der dritte Fehlerindikator kann dabei dem Bild zugeordnet werden bzw. zuordenbar sein. Bspw. kann das Ergebnis der Befundung im Schritt 11a sein, dass die Leiterplatte tatsächlich fehlerfrei ist, jedoch die optische Bildverarbeitung diese irrtümlich als fehlerhaft erkannt hat.

Bereits die Schritte Slla und S12 können mehrfach wiederholt werden, bspw. bis eine vorgegebene Anzahl an Bildern vorliegt, bei denen die Befundung eine fehlerfrei Leiterplatte ergeben hat.

In einem optionalen Schritt S13 können, vorzugsweise zum (Nach-)Trainieren des lernfähigen Algorithmus, des Bildes bzw. eines oder mehrerer Bildbereiche augmentiert werden. Das Augmentieren dient dabei dazu synthetische Bilder zu erzeugen, um die Anzahl der Bilder anhand denen der lernfähige Algorithmus trainiert wird zu erhöhen.

In einem Schritt S14 kann dann das (Nach-)Trainieren des lernfähigen Algorithmus basierend auf dem dritten Fehlerindikator und dem Bild bzw. den augmentierten Bildern der Leiterplatte erfolgen.

Gem. einem Schritt S15 kann dann wieder Schritt Slla ausgeführt werden, um Bilder für das erneute (Nach)Trainieren des lernfähigen Algorithmus zu erhalten und bspw. den First-Pass-Yield bei der Fertigung der Leiterplatten zu erhöhen.

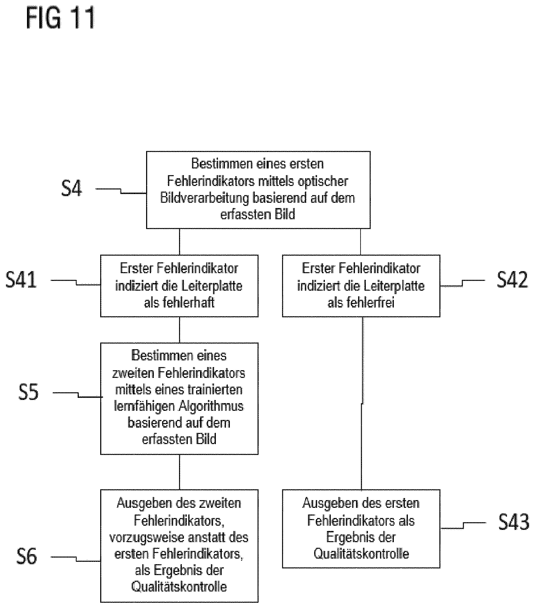

FIG 11 zeigt eine schematische Darstellung eines Verfahrens gemäß einer vierten Ausführungsform. In einem Schritt S4 kann wie beschrieben das Bestimmen eines ersten Fehlerindikators mittels optischer Bildverarbeitung basierend auf dem erfassten Bild erfolgen. In Abhängigkeit davon, ob der erste Fehlerindikator die Leiterplatte als fehlerhaft oder fehlerfrei indiziert wird dann die Qualitätskontrolle fortgesetzt.

In dem Fall, dass der erster Fehlerindikator gem. Schritt S41 die Leiterplatte als fehlerhaft indiziert, wird in einem Schritt S5 eine zweiter Fehlerindikator mittels eines trainierten lernfähigen Algorithmus basierend auf dem erfassten Bild bestimmt. Anschließend wird wie beschrieben in einem Schritt S6 der zweite Fehlerindikator, vorzugsweise anstatt des ersten Fehlerindikators, als Ergebnis der Qualitätskontrolle, ausgegeben. Das Ausgeben kann dabei in eine Datei erfolgen oder in Form einer visuellen Anzeige erfolgen.

Für den Fall, dass der erste Fehlerindikator gem. Schritt S42 die Leiterplatte als fehlerfrei indiziert wird einem, ggf. unmittelbar, darauffolgen Schritt S43 der erste Fehlerindikator als Ergebnis der Qualitätskontrolle ausgegeben.

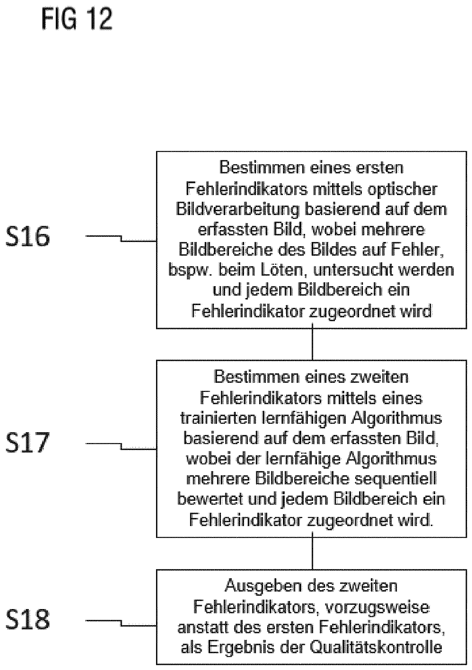

FIG 12 zeigt eine schematische Darstellung eines Verfahrens gemäß einer fünften Ausführungsform. In einem Schritt S16 kann ein erster Fehlerindikator mittels optischer Bildverarbeitung basierend auf dem erfassten Bild bestimmt werden, wobei mehrere Bildbereiche des Bildes auf Fehler, bspw. beim Löten, untersucht werden und jedem Bildbereich ein Fehlerindikator zugeordnet wird. Ein von der (gesamten) Leiterplatte erfasstes Bild kann in mehrere Bildbereiche geteilt werden. Dabei kann ein Bildbereich ein oder mehrere Lötstellen umfassen. Ferner kann ein Bildbereich einem oder mehreren Prüffeldern entsprechen, in denen die zu prüfenden Lötstellen liegen.

In einem Schritt S17 kann eine zweiter Fehlerindikator mittels eines trainierten lernfähigen Algorithmus basierend auf dem erfassten Bild bestimmt werden, wobei der lernfähige Algorithmus mehrere Bildbereiche sequentiell bewertet und jedem Bildbereich ein Fehlerindikator zugeordnet wird.

In einem Schritt S18 kann dann der zweite Fehlerindikator bzw. einer der zweiten Fehlerindikatoren, vorzugsweise anstatt des ersten Fehlerindikators, als Ergebnis der Qualitätskontrolle ausgegeben werden.

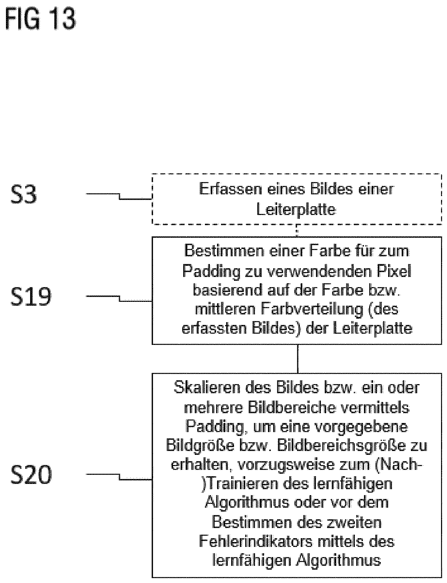

FIG 13 zeigt eine schematische Darstellung eines Verfahrens gemäß einer sechsten Ausführungsform. Wie beschrieben kann in einem Schritt S3 eine Bild einer Leiterplatte erfasst werden. In einem Schritt S19 kann eine Farbe für zum Padding zu verwendenden Pixel basierend auf der Farbe bzw. mittleren Farb-verteilung (des erfassten Bildes) der Leiterplatte bestimmt werden.

In einem Schritt S20 kann das Bild bzw. ein oder mehrere Bildbereiche vermittels Padding skaliert werden, um eine vorgegebene Bildgröße bzw. Bildbereichsgröße zu erhalten, vorzugsweise zum (Nach-)Trainieren des lernfähigen Algorithmus oder vor dem Bestimmen des zweiten Fehlerindikators mittels des lernfähigen Algorithmus.

Das vorgeschlagene Computerprogrammprodukt kann Programmcodemittel aufweisen, die wenn sie ausgeführt werden, zur Durchführung des Verfahrens nach einem oder mehrere der Schritte S1 bis S29 dienen. Dabei kann das Computerprogrammprodukt bspw. auf einem Inspektionssystem gespeichert und/oder von diesem ausgeführt werden. Bspw. kann das Computerprogrammprodukt das erste und/oder (nur) das zweite Softwaremodul SWM1 bzw. SWM 2 umfassen.

## Patentansprüche

1. Verfahren zur optischen Qualitätskontrolle (Q) während der Fertigung (1) von Leiterplatten (L), umfassend:
Erfassen (S3) eines Bildes (P1) einer Leiterplatte (L), und
Bestimmen (S4) eines ersten Fehlerindikators (F1) mittels optischer Bildverarbeitung basierend auf dem erfassten Bild,
Bestimmen (S5) eines zweiten Fehlerindikators (F2) mittels eines trainierten lernfähigen Algorithmus (ML) basierend auf dem erfassten Bild (P1), und
Ausgeben (S6) des zweiten Fehlerindikators (F2), vorzugsweise anstatt des ersten Fehlerindikators (F1), als Ergebnis der Qualitätskontrolle (Q).

2. Verfahren nach dem vorherigen Anspruch, ferner umfassend:
Verarbeiten (S7) des erfassten Bildes (P1) und Bestimmen (S8) des ersten Fehlerindikators von einem ersten Softwaremodul (SWM1), das die optische Bildverarbeitung (OR) ausführt, und
Verarbeiten (S9) des erfassten Bildes (P1) und Bestimmen (S10) des zweiten Fehlerindikators (F2) von einem zweiten Softwaremodul (SWM2), das den trainierten lernfähigen Algorithmus (ML) ausführt, wobei bspw. das erfasste Bild (P1), vorzugsweise in Form von Bilddaten, besonders bevorzugt in Form einer Bilddatei, in einem geteilten Dateisystem gespeichert wird.

3. Verfahren nach einem der vorherigen Ansprüche, ferner umfassend:
Ausgeben (S11), bspw. in Form einer Zeichenkette, vorzugsweise in eine Datei, welche Datei den ersten und/oder zweiten Fehlerindikator (F1, F2) enthält, des zweiten Fehlerindikators (F2) als Ergebnis der Qualitätskontrolle (Q), bevorzugt mittels des ersten Softwaremoduls (SWM1).

4. Verfahren nach einem der vorherigen Ansprüche, ferner umfassend:
Befunden (S11) einer aufgrund des Ergebnisses der Qualitätskontrolle (Q) als fehlerhaft indizierten Leiterplatte (L), und
Erfassen (S12) eines dritten Fehlerindikators (F3) der als fehlerhaft indizierten Leiterplatte (L) und Speichern des dritten Fehlerindikators und des Bildes (P1) der Leiterplatte (L),
(Nach-)Trainieren (S14) des lernfähigen Algorithmus (ML) basierend auf dem dritten Fehlerindikator (F3) und dem Bild (P1) der Leiterplatte (L).

5. Verfahren nach einem der vorherigen Ansprüche, ferner umfassend:
wiederholtes, vorzugsweise periodisches, Ausführen der Schritte wenigstens eines der vorherigen Ansprüche (S15), bspw. bis eine vorgegebene First-Pass-Yield-Quote erreicht ist, um bspw. geänderte Bedingungen bei der Fertigung der Leiterplatte(n) (L) zu erfassen.

6. Verfahren nach einem der vorherigen Ansprüche, ferner umfassend:
wobei in dem Fall, dass der mittels der optischen Bildverarbeitung (OR) bestimmte erste Fehlerindikator (F1) die Leiterplatte (L) als fehlerhaft indiziert (S41),
mittels des trainierten lernfähigen Algorithmus (ML) der zweite Fehlerindikator (F2) bestimmt wird (S5).

7. Verfahren nach einem der vorherigen Ansprüche, ferner umfassend:
wobei in dem Fall, dass der mittels der optischen Bildverarbeitung (OR) bestimmte erste Fehlerindikator (F1) die Leiterplatte (L) als fehlerfrei indiziert (S42),
das Bestimmen des zweite Fehlerindikators (F2) mittels des trainierten lernfähigen Algorithmus (ML) nicht ausgeführt wird (S43).

8. Verfahren nach einem der vorherigen Ansprüche, ferner umfassend:
Bestücken (S1) der Leiterplatte (L) mit elektrischen und/oder elektronischen Bauteilen (BT1, BT2, BT3), bspw. an einem Bestückplatz (B),
Löten (S2) der Bauteile (BT1, BT2, BT3) an die Leiterplatte (L), bspw. mittels einer Wellenlötmaschine (W).

9. Verfahren nach einem der vorherigen Ansprüche, ferner umfassend:
Bestimmen (S16) eines ersten Fehlerindikators (F1) mittels optischer Bildverarbeitung (OR) basierend auf dem erfassten Bild (P1), wobei mehrere Bildbereiche (C1, ...,C8) des Bildes auf Fehler, vorzugsweise beim Löten, untersucht werden und jedem Bildbereich (C1, ...,C8) ein Fehlerindikator zugeordnet wird.

10. Verfahren nach einem der vorherigen Ansprüche, ferner umfassend:
Bestimmen (S17) eines zweiten Fehlerindikators (F2) mittels des trainierten lernfähigen Algorithmus (ML) basierend auf dem erfassten Bild (P1), wobei der lernfähige Algorithmus (ML) mehrere Bildbereiche (C1, ..., C8) sequentiell bewertet und jedem Bildbereich (C1, ...,C8) ein Fehlerindikator zugeordnet wird.

11. Verfahren nach einem der vorherigen Ansprüche, ferner umfassend:
Skalieren (S20) des Bildes bzw. ein oder mehrere Bildbereiche vermittels Padding, um eine vorgegebene Bildgröße bzw. Bildbereichsgröße zu erhalten, vorzugsweise zum (Nach-)Trainieren des lernfähigen Algorithmus (ML) oder vor dem Bestimmen des zweiten Fehlerindikators (F2) mittels des lernfähigen Algorithmus (ML),
wobei vorzugsweise eine Farbe der zum Padding verwendeten Pixel basierend auf der Farbe bzw. mittleren Farbverteilung der Leiterplatte (L) bestimmt wird (S19).

12. Verfahren nach einem der vorherigen Ansprüche, ferner umfassend:
Augmentieren (S13), vorzugsweise zum (Nach-)Trainieren des lernfähigen Algorithmus (ML), des Bildes (P1) bzw. der Bildbereiche (C1, ..., C8) .

13. Verfahren nach einem der vorherigen Ansprüche,
wobei der lernfähige Algorithmus (ML) einen erste und einen zweiten trainierbaren Teil umfasst, und wobei der zweite Teil anhand des dritten Fehlerindikators (F3) (nach-)trainiert wird,
wobei vorzugsweise der lernfähige Algorithmus (ML) zum Bestimmen des zweiten Fehlerindikators vermittels des lernfähigen Algorithmus Ensemble Learning verwendet.

14. Verfahren nach einem der vorherigen Ansprüche,
wobei vermittels wenigstens eines Autoencoders (AE), vorzugsweise eines Autoencoders pro Fehlerkategorie, das erfasste Bild (P1) bzw. der Bildbereich (C1, ..., C8) rekonstruiert wird, und dass wenn ein Rekonstruktionsfehler des Autoencoders einen Schwellenwert überschreitet, das Bild (P1) bzw. der Bildbereich (C1, ..., C8) nicht zum Bestimmen des zweiten Fehlerindikators (F2) vermittels des lernfähigen Algorithmus verwendet wird, und dass vorzugsweise eine Befundung Leiterplatte vorgenommen wird, um bspw. einen dritten Fehlerindikator (F3) zu bestimmen.

15. Vorrichtung, insbesondere Inspektionssystem zur Qualitätskontrolle (Q) von Leiterplatten, zur Durchführung des Verfahrens nach einem der vorherigen Ansprüche.

16. Computerprogrammprodukt mit Programmcodemitteln, die wenn sie ausgeführt werden, zur Durchführung des Verfahrens nach einem der vorherigen Ansprüche 1 bis 14 dienen.
